(19) Europäisches Patentamt

European Patent Office

Office européen des brevets

(11) EP 1 329 965 A1

(12) EUROPEAN PATENT APPLICATION
published in accordance with Art. 158(3) EPC

(43) Date of publication:
23.07.2003 Bulletin 2003/30

(51) Int Cl.7: H01L 51/10, H01L 27/04

(21) Application number: 00969987.7

(22) Date of filing: 23.10.2000

(86) International application number:
PCT/JP00/07376

(87) International publication number:
WO 02/035616 (02.05.2002 Gazette 2002/18)

(84) Designated Contracting States:
AT BE CH CY DE DK ES FI FR GB GR IE IT LI LU
MC NL PT SE
Designated Extension States:
AL LT LV MK RO SI

(71) Applicants:
• Sony Corporation
Tokyo 141-0001 (JP)
• Sony International (Europe) GmbH
10785 Berlin (DE)

(72) Inventors:
• NELLES, Gabriele,
Sony International (Europe) GMBH
D-70327 Stuttgart (DE)

• YASUDA, Akio,
Sony International (Europe) GMBH
D-70327 Stuttgart (DE)
• ISHIBASHI, Akira, Sony Corporation
Tokyo 141-0001 (JP)

(74) Representative: Müller, Frithjof E., Dipl.-Ing.
Müller Hoffmann & Partner
Patentanwälte
Innere Wiener Strasse 17
81667 München (DE)

(54) **NEURON AGGREGATION DEVICE**

(57)     A connected neuronal structure layer, having a large number of neurons connected to each other to form a network, is sandwiched from its top and bottom by a neuron observation layer and a neuron setting layer to form a connected neuronal structure device. The connected neuronal structure layer is made up of neurons having grown from the neuron setting layer by, for example, self-organized progressive hierarchy acquisition. Growth distribution of neurons can be controlled by means of an electric field, photon delivery, vibration field, or the like. The neuron observation layer functions as a detector.

**Fig. 3**

## Description

Technical Field

This invention relates to a connected neuronal structure device suitable for use in, for example, characteristic analysis of a neuronal system.

Background Art

Characteristic analysis of biological systems, and in particular, of neuron systems, has become more and more important.

As a neuronal system as the subject of characteristic analysis, a coupled neuronal system that is a massively connected neuronal system like a human brain can be taken. A representative technique for observing functions and reactions of a connected neuronal system is to stick a probe from the exterior and detect electric signals through the probe. From the viewpoint of macroscopically observing behaviors of a neuronal system, NMR (nuclear magnetic resonance) and CT scan (computerized tomographic scan), for example, are representative techniques.

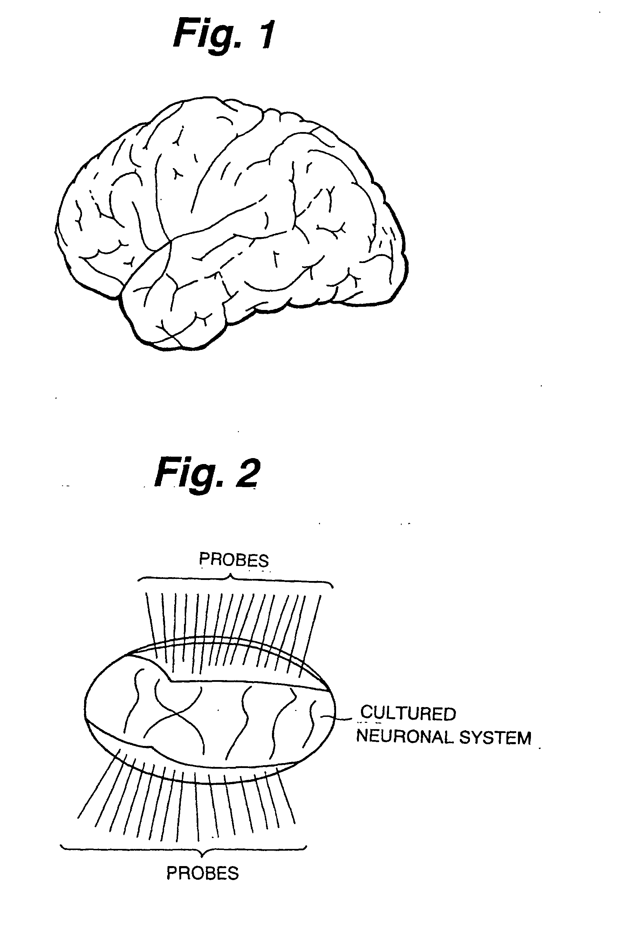

However, the number of probes that can be stuck into the connected neuronal' system as shown in Fig. 1 is limitative as a matter of course, and NMR, CT scan and like techniques are only available for macroscopic observation. Therefore, it has been difficult, for example, to observe individual signals from individual neurons.

Those situations have disturbed analysis of connected neuronal systems, and this fact has invited the situation not enabling it sufficiently to make more sophisticated artificial objects learning of living bodies and add new functions. There is certainly a steady progress from the viewpoint of LSI alone, organic functional substances alone, or optical control alone. Currently, however, because of insufficient analyses of connected neuronal systems as mentioned above, sophistication of living body systems, even though being under the control of genes, are not always under the control of brains.

It is therefore an object of the invention to break the limit of those conventional neuronal systems and to provide a connected neuronal structure device capable of detecting signals from individual neurons and more detailed characteristic analyses, and thereby available for wide applications.

Disclosure of Invention

The Inventor contemplated the use of a neuronal system schematically shown in Fig. 2 instead of conventional neuronal systems as the subject of observation. As shown in Fig. 2, the neuronal system includes a large number of probes densely arrayed on one side and the other side of a cultured neuronal system and brought into contact with individual neurons so as to enable detection of signals from individual neurons or control of individual neurons by using those probes.

That is, to accomplish the object, the first aspect of the invention is a connected neuronal structure device comprising:

a connected neural structure; and
a plurality of element layers connected to said connected neural structure at different sites.

According to the second aspect of the invention, there is provided a connected neural device characterized in having a structure interposing a connected neuronal structure layer between a pair of element layers.

The element layers include a plurality of electronic elements, or include a plurality of optical elements and a plurality of electronic elements. One of the pair of element layers forms a setting system of the connected neuronal structure layer whereas the other element layer forms an observation system of the connected neuronal structure layer. The element layer forming the observation system of the connected neuronal structure layer, for example, includes pads or gate arrays in a two-dimensional arrangement. Typically, it includes pads or gate arrays and a variable wiring layer in a two-dimensional arrangement. On the other hand, the element layer forming the setting system of the connected neuronal structure layer includes, for example, includes a substance variable in volume, which is configured to generate a two-dimensional electric field, configured to be capable of two-dimensional photon delivery, configured to generate a two-dimensional vibration field, or arranged in a two-dimensional manner. Those configurations can control the growth of neurons. The element layer forming the setting system of the connected neuronal structure layer typically has, at least, the function of controlling the growth of neurons and the function of education of the connected neural structure layer. The connected neural structure layer is a two-dimensional or three-dimensional neuron system. The connected neural structure layer is multilayered, stacking two or more layers, if necessary.

Brief Description of Drawings

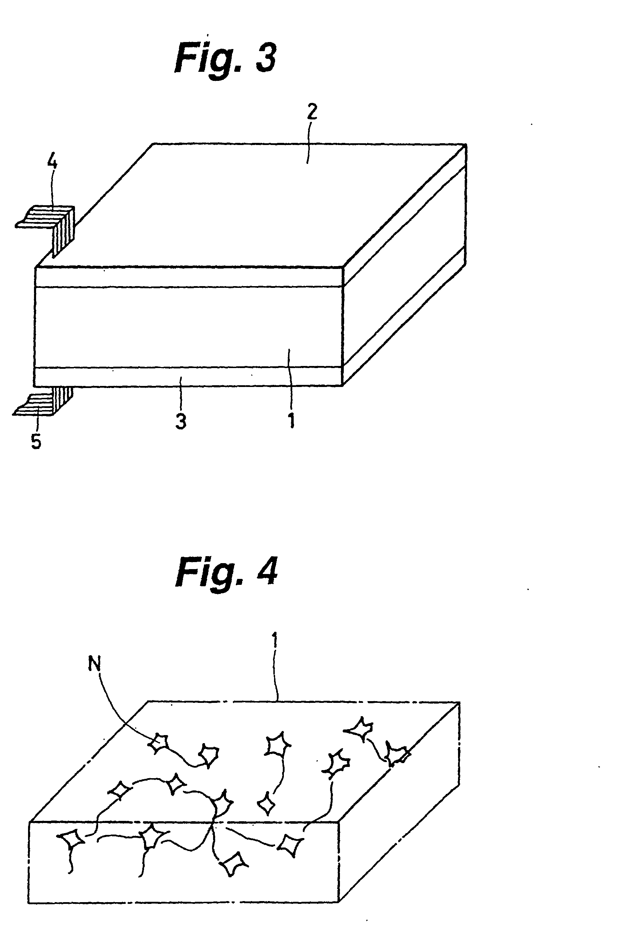

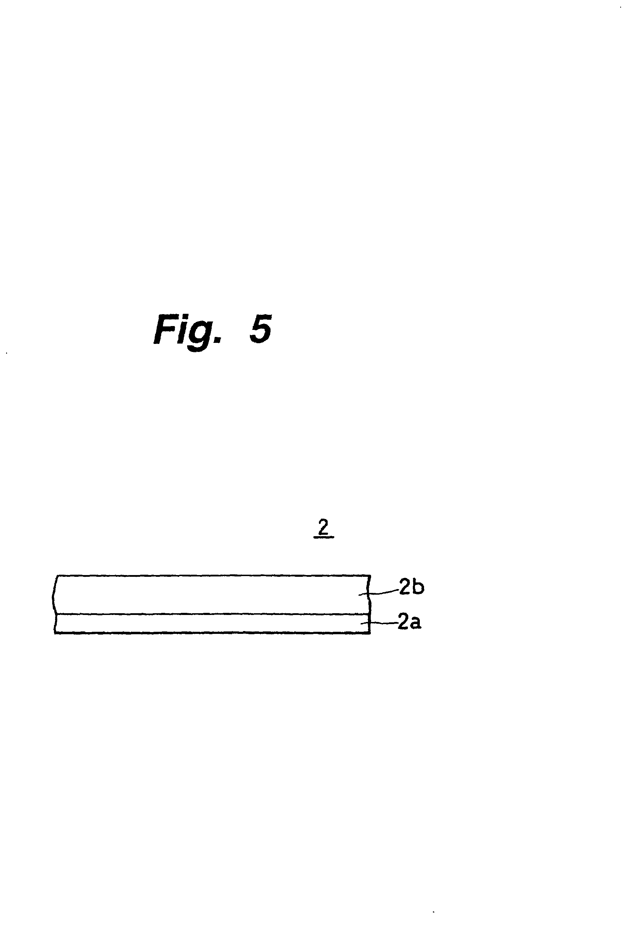

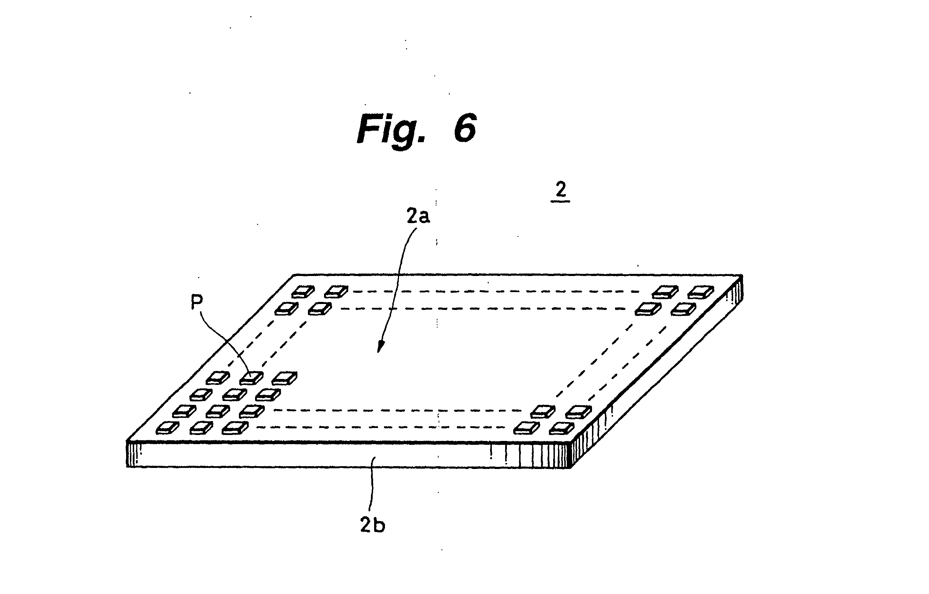

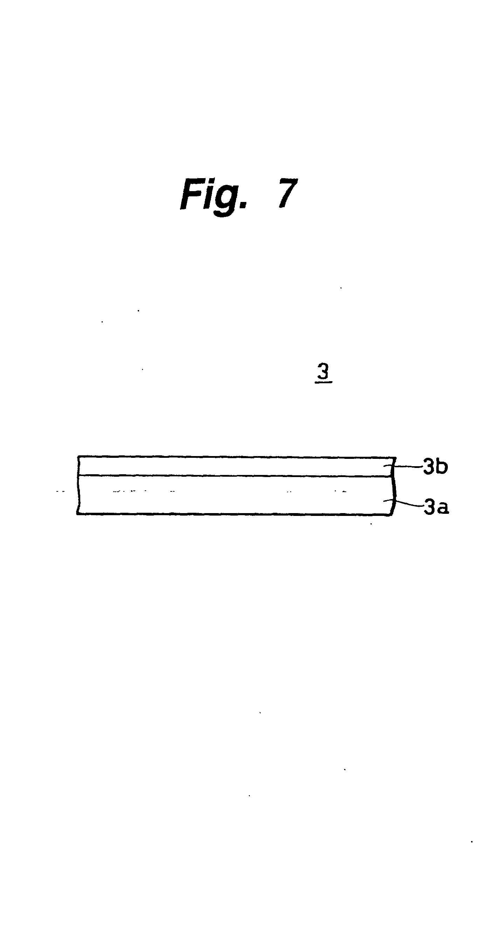

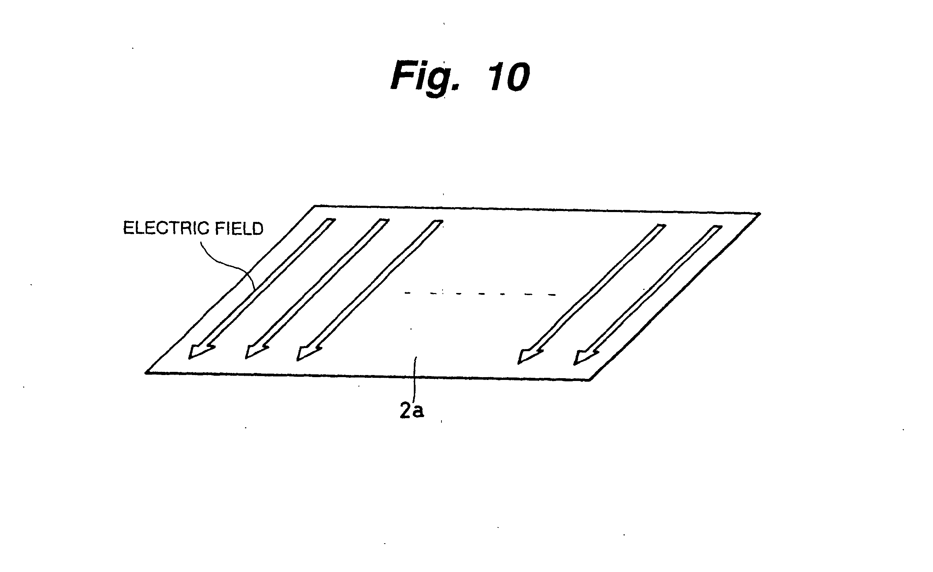

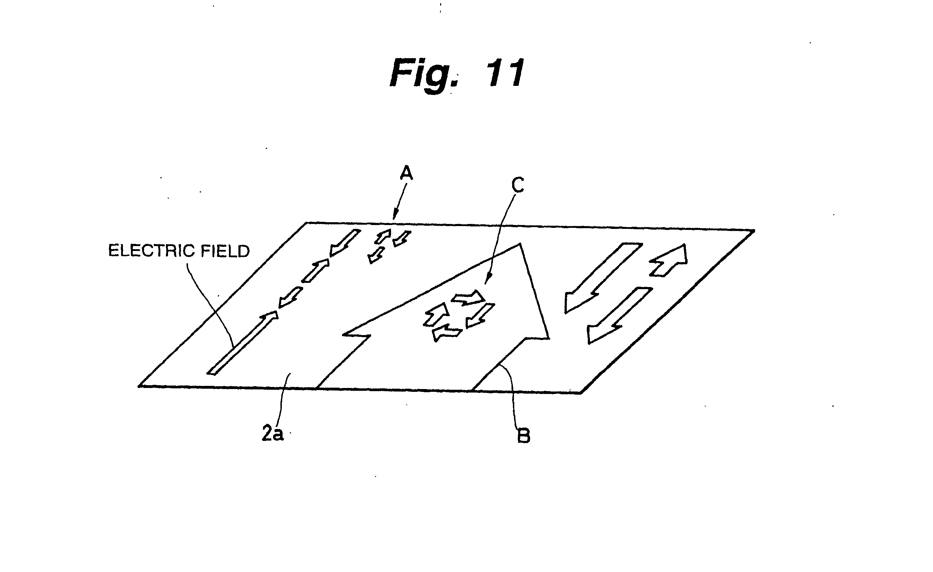

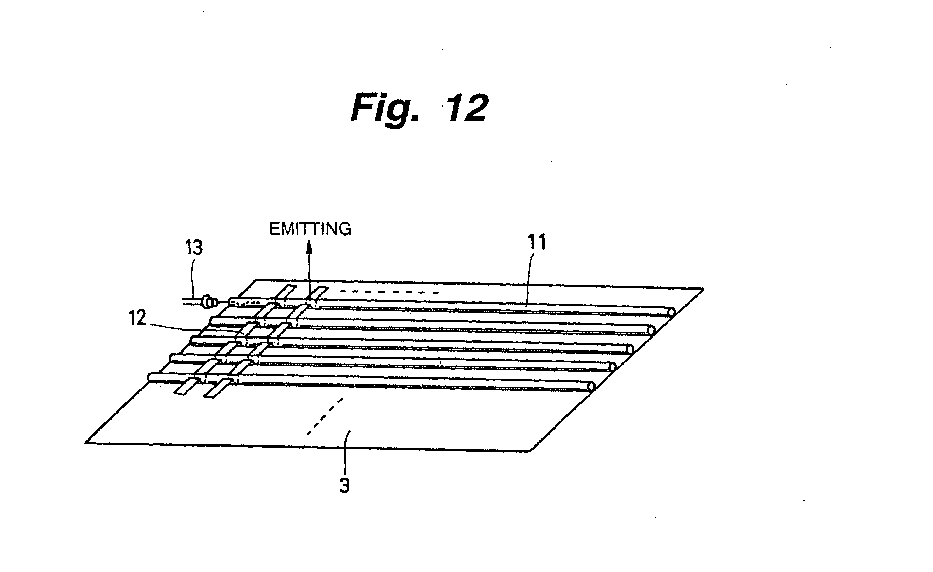

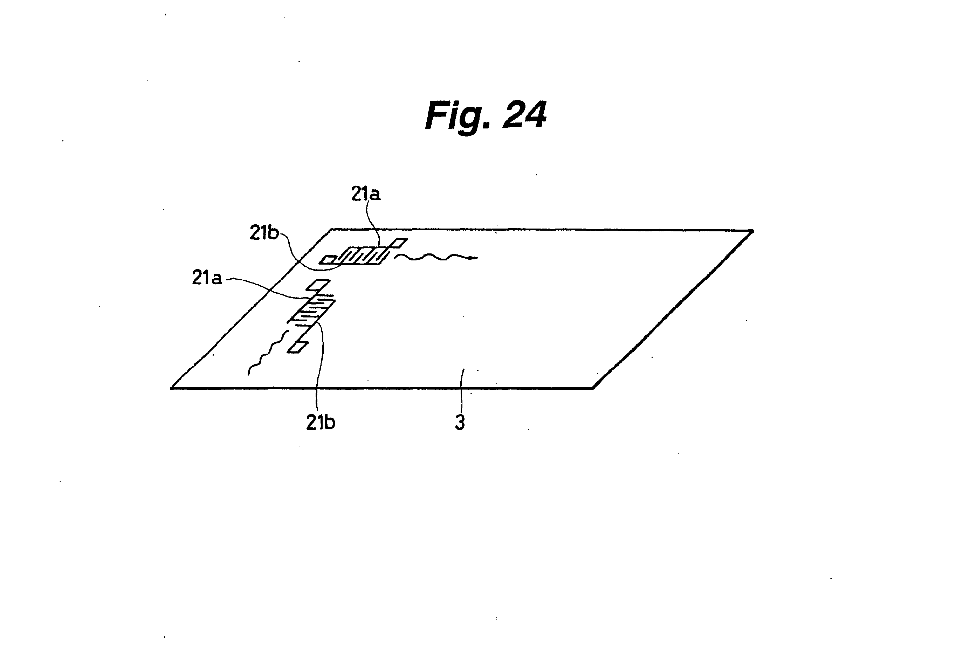

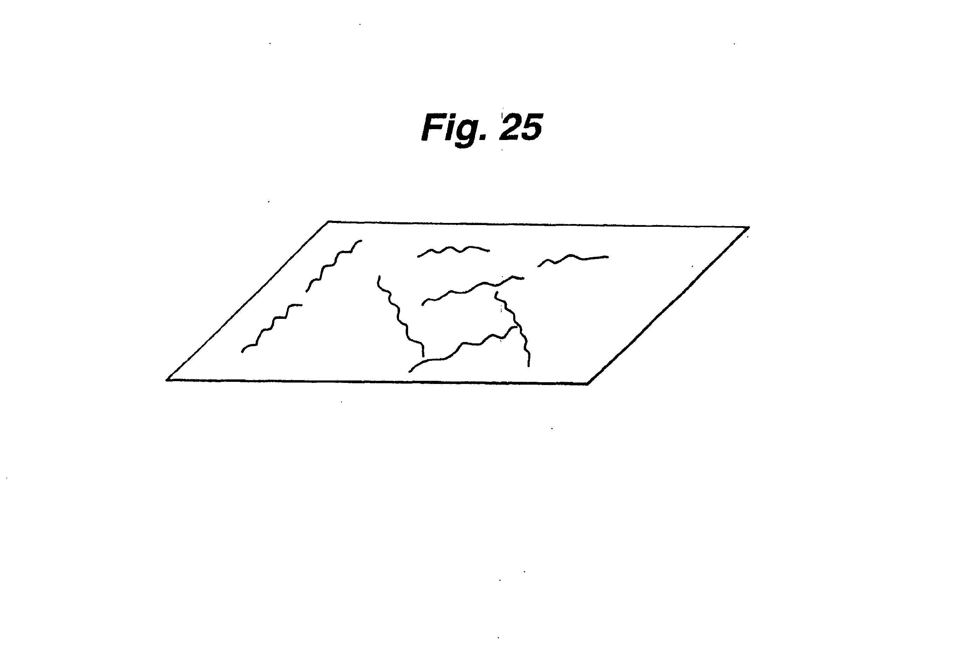

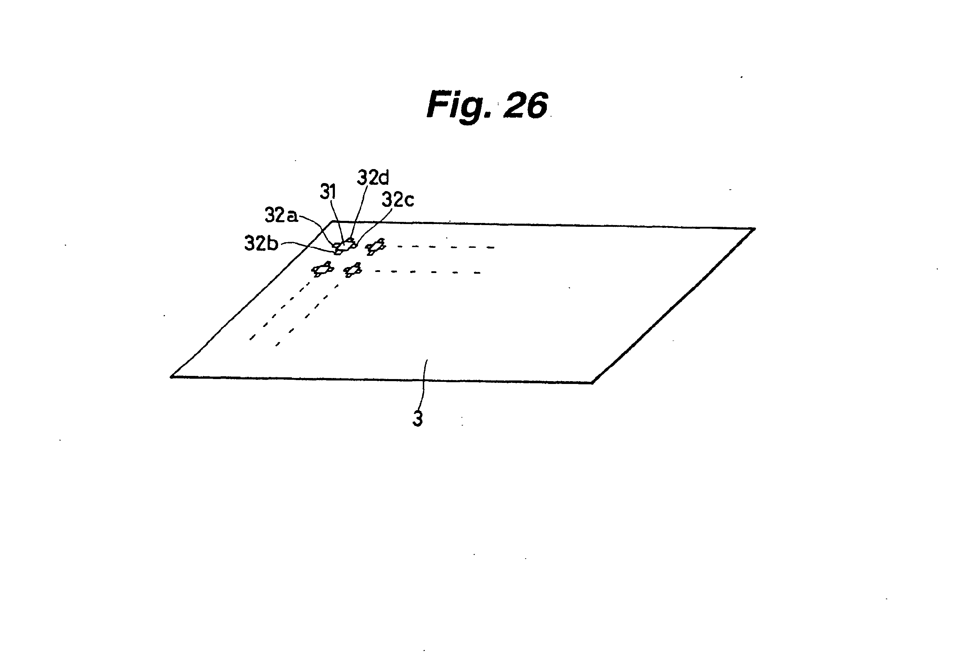

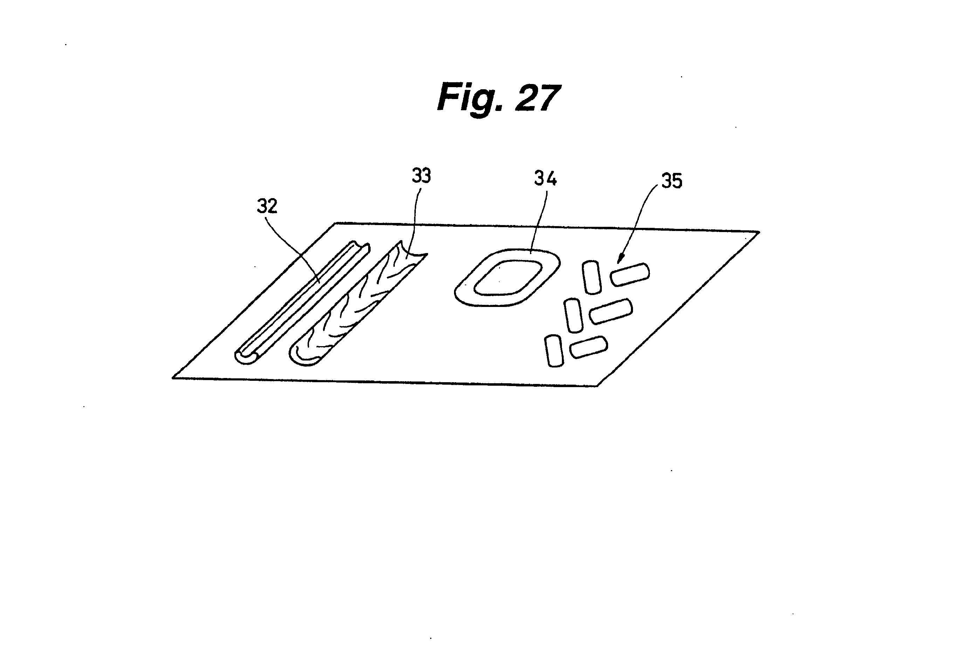

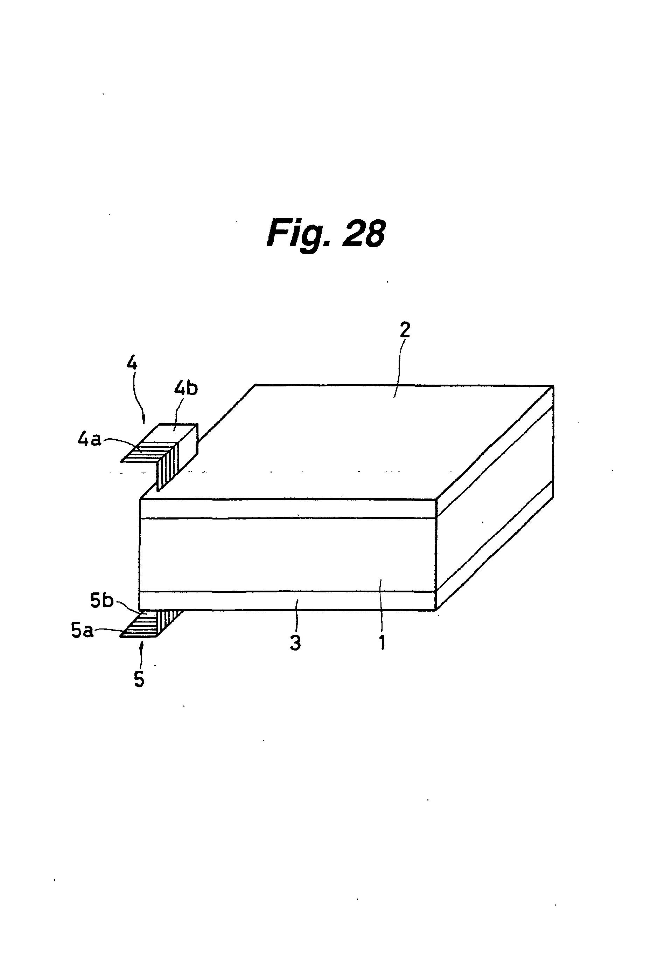

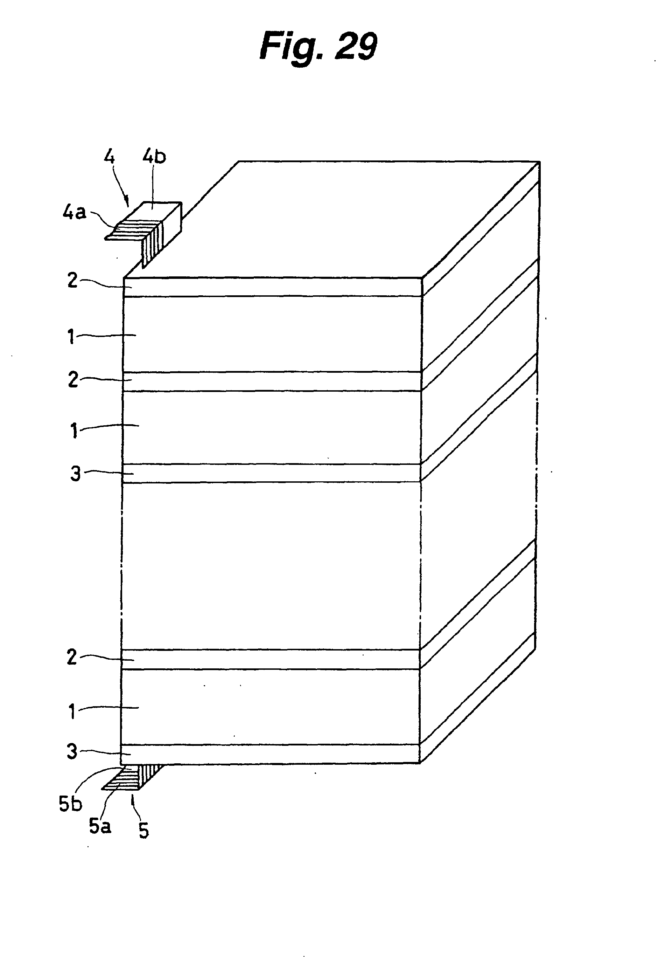

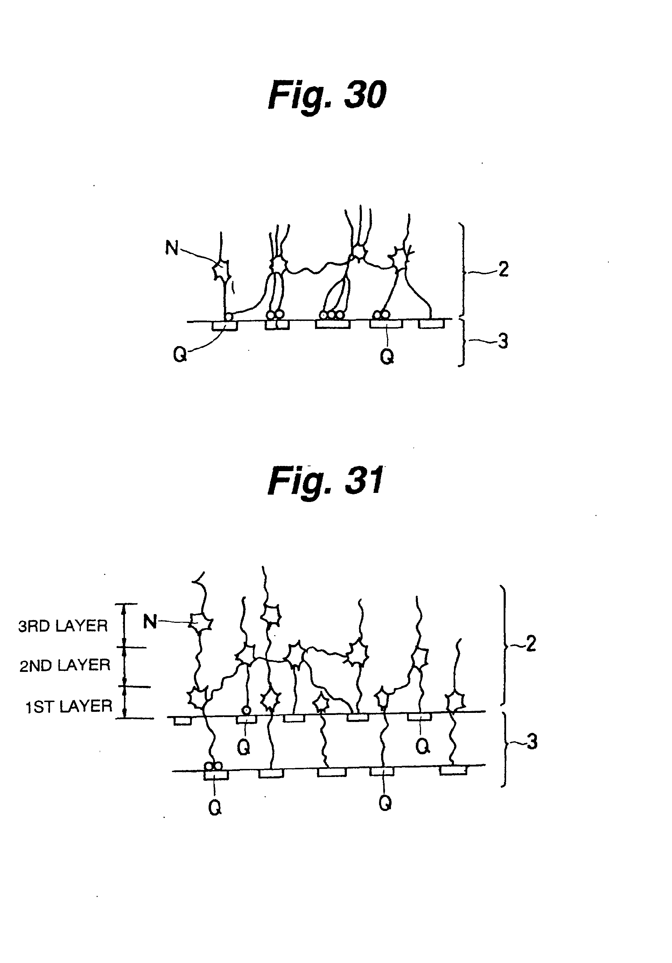

Fig. 1 is a schematic diagram that shows a human brain; Fig. 2 is a schematic diagram that schematically shows a connected neuronal structure device according to the invention; Fig. 3 is a schematic diagram that shows a connected neuronal structure device according to the first embodiment of the invention; Fig. 4 is a cross-sectional view that shows a configuration of the connected neuronal structure layer in the connected neuronal structure device according to the first embodiment of the invention; Fig. 5 and Fig. 6 are cross-sectional views that show configurations of a neuron observation layer in the connected neuronal structure device according to the first embodiment of the invention; Figs. 7 through 9 are cross-sectional views that show configurations of a neuron setting layer in the connected neuronal structure device according to the first embodiment of the invention; Figs. 10 and 11 are schematic diagrams for explaining a method of controlling the growth of neurons by the neuron setting layer in the connected neuronal structure device according to the first embodiment of the invention; Figs. 12 through 23 are schematic diagrams for explaining a method of controlling the growth of neurons by the neuron setting layer in a connected neuronal structure device according to the second embodiment of the invention; Figs. 24 and 25 are schematic diagrams for explaining a method of controlling the growth of neurons by the neuron setting layer in a connected neuronal structure device according to the third embodiment of the invention; Figs. 26 and 27 are schematic diagrams for explaining a method of controlling the growth of neurons by the neuron setting layer in a connected neuronal structure device according to the fourth embodiment of the invention; Fig. 28 is a schematic diagram that shows a connected neuronal structure device according to the fifth embodiment of the invention; Fig. 29 is a schematic diagram that shows a connected neuronal structure device according to the sixth embodiment of the invention; Fig. 30 is a schematic diagram that shows a connected neuronal structure device according to the seventh embodiment of the invention; and Fig. 31 is a schematic diagram that shows the connected neuronal structure device according to the seventh embodiment of the invention.

Best Mode for Carrying Out the Invention

Some embodiments of the invention will now be explained below with reference to the drawings.

Fig. 3 shows a connected neuronal structure device according to the first embodiment of the invention. As shown in Fig. 3, the connected neuronal structure device has a structure in which a neuron observation layer 2 and a neuron setting layer 3 sandwich, from the top and the bottom, a connected neuronal structure layer 1 including a large number of neurons connected together to form a network. An electrical bus line 4 is connected to an output terminal of the neuron observation layer 2, and an electrical bus line 5 is connected to an output terminal of the neuron setting layer 3.

The connected neuronal structure layer 1 is made of neurons N having grown from the neuron setting layer 3 as shown, for example, in Fig. 4. Neurons are typically grown by self-organized progressive hierarchy acquisition.

The neuron observation layer 2 has the role as a detector. As shown in Fig. 5, the neuron observation layer 2 has a double structure including a pad array layer 2a and a variable wiring layer 2b. The part of the pad array layer 2a is connected to the connected neuronal structure layer 1.

Fig. 6 shows an exemplary structure of the pad array layer 2a. Fig. 6 is a view of the neuron observation layer 2 taken from the surface of the pad array layer 2a. As shown in Fig. 6, the pad array layer 2a includes fine pad electrodes P arranged in a two-dimensional array. The pitch of the pad electrodes P is selected to be substantially equal to the average arrangement pitch of neurons on the connected neuronal structure layer 1 along the contact surface with the pad array layer 2a to enable the maximum detection of signals from those neurons.

The variable wiring layer 2b is made of LSI rewritable in wiring connection. More specifically, it is made of, for example, a field programmable logic array (FPLA). FPLA is an array of a number of rows and columns of wiring intersections that are turned ON and OFF to change the wiring connection. There are some types of FPLA relying on fuse meltdown, connection breakdown or irradiation of laser beams, for example, to turn ON and OFF of the wiring intersections. Although there are FPLAs using MOS devices or bipolar devices, those using TTL are often used. The variable wiring layer 2b is typically made by using a silicon substrate or a silicon layer.

The neuron setting layer 3 controls the growth of neurons forming the connected neuronal structure layer 1, and after the growth of the neurons, achieves the role of education and/or growth of the neuronal system. As shown in Fig. 7, the neuron setting layer 3 has a double structure including an LSI substrate 3a and a pad array layer 3b. The part of the pad array layer 3b is connected to the connected neuronal structure layer 1.

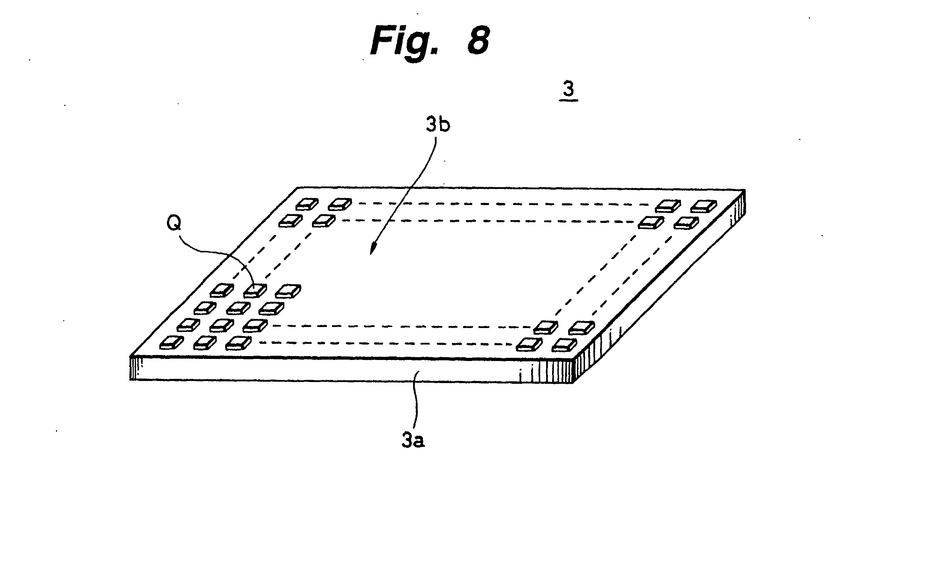

The LSI substrate 3a is a substrate having formed an electronic circuit in which transistors and other necessary elements are built in. It is a semiconductor substrate such as a silicon substrate. An output terminal of the electronic circuit formed on the LSI substrate 3a and the pad electrodes forming the pad array layer 3c are connected electrically. Fig. 8 shows an exemplary structure of the pad array layer 3b coupled to the connected neuronal structure layer 1. Fig. 8 is a view of the neuron setting layer 3 taken from the surface of the pad array layer 3b. As shown in Fig. 8, the pad array layer 3b includes fine pad electrodes Q arranged in a two-dimensional array. The pitch of the pad electrodes Q is determined depending on neurons to be grown. Usually, however, for the purpose of growing neurons by self-organized progressive hierarchy acquisition, it is selected to be slightly larger than the pitch of the pad electrodes P in the pad array layer 2b of the neuron observation layer 2. In this case, in order to limit the growth starting positions of neurons on the pad electrodes, liquid crystal layers LC are preferably formed on individual pad electrodes Q beforehand as shown in Fig. 8. A polymeric side chain liquid crystal is used as the liquid crystal layers LC, and polyester or polypeptide is selected as the polymer.

Next explained is a manufacturing method of the connected neuronal structure device according to the first embodiment having the above-explained configuration.

First prepared is the neuron setting layer 3. The LSI substrate 3a and the pad array layer 3b forming the neuron setting layer 3 are designed beforehand in accordance with the connected neuronal structure layer 1 to be formed. Liquid crystal layers LC are formed beforehand on individual pad electrodes Q of the pad array layer 3b.

After that, in an appropriate culture fluid prepared beforehand, neurons are grown on the neuron setting layer 3 by self-organized progressive hierarchy acquisition to form the connected neuronal structure layer 1. In this process, neurons preferentially grow on individual pad electrodes Q due to molecular orientation. Growth of neurons can be controlled by a method explained later.

Subsequently, the pad array layer 2a of the neuron observation layer 2 formed beforehand is coupled onto the connected neuronal structure layer 1. Although the neurons forming the connected neuronal structure layer 1 grow by self-organized progressive hierarchy acquisition as explained above, three-dimensional arrangement of these neurons can be controlled only roughly, correspondence of the neurons and the pad electrodes P forming the pad array layer 2a are not clear at that time. Therefore, the connected neuronal structure layer 1 under that condition is observed by the neuron observation layer 2 to identify correspondence of the neurons and individual pad electrodes P forming the pad array layer 2a. More specifically, which pad electrode P each neuron is connected to is reviewed. When such correspondence between neurons and pad electrodes P forming the pad array layer 2a is clarified in this manner, wiring connection of the variable wiring layer 2b is changed at any necessary positions.

After that, bus lines 4, 5 are formed in the neuron observation layer 2 and the neuron setting layer 3, respectively.

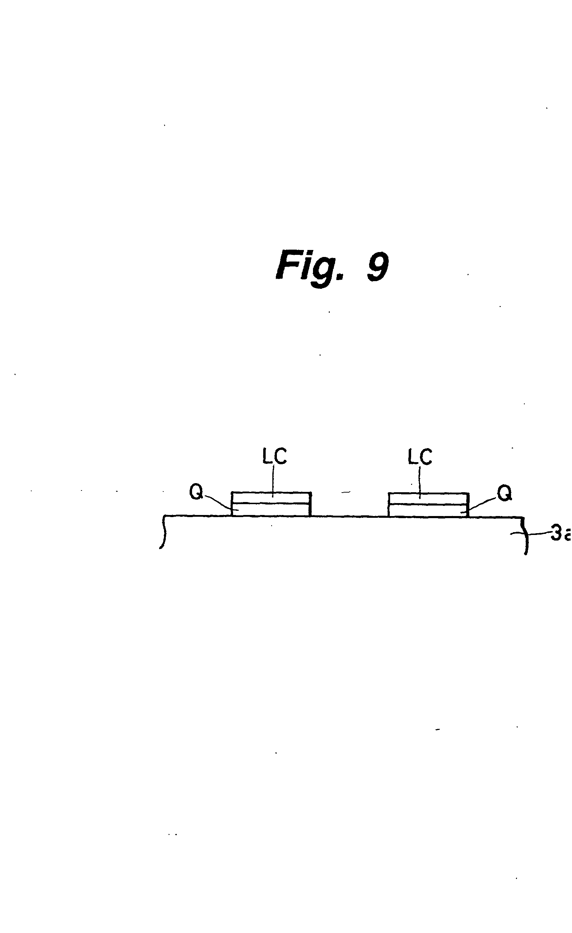

A method of controlling the growth profile of neurons will be explained below. In this case, an electric field is used for this control. More specifically, an arbitrary distribution of electric field is generated within a two-dimensional plane by applying an adequate voltage to respective pad electrodes P of the pad array layer 2a. Figs. 8 and 9 illustrates such examples. In the method shown in Fig. 8, a two-dimensional uniform electric field as shown by arrows is generated by gradually decreasing the voltage applied to individual pad electrodes P of he pad array layer 2a in a stepwise manner. In the method shown in Fig. 9, a two-dimensional electric field including a region with a mosaic distribution of electric field (shown by the arrow A), a region of a wide distribution of electric field (shown by the arrow B), a region of a spiral distribution of electric field (shown by the arrow C), and others, is generated by adequately controlling the voltage applied to the pad electrodes P of the pad array layer 2a from one region to another. Furthermore, it is also possible to change the two-dimensional electric field as the vector field with time, thereby to control the growth of neurons by or to observe the progress of the growth of neurons by means of the neuron observation layer 2.

Behaviors of the connected neuronal structure device are explained below. That is, in the operative mode of the connected neuronal structure device, the output Out(x,y) in the neuron observation layer 2 is given as the function F of the input In(x,y) to the neuron setting layer 3 by the connected neuronal structure layer 1. That is, Qut(x,y)=F(In(x,y)). F is the product of two functions, i.e. a growth function G and a response (reactive education) function R. That is, F=G·R.

In the connected neuronal structure device according to the first embodiment, signals from individual neurons of the connected neuronal structure layer 1 can be detected by the neuron observation layer 2, and detailed characteristic analysis of the neuronal system is possible.

In addition, the connected neuronal structure device can also deal with information processing. That is, it is possible to supply a signal of input information to the neuron setting layer 3, process the information in the connected neuronal structure layer 1 and extract the result as an output from he neuron observation layer 2. In this process, if the result of information processing in a neuron layer of N-1 hierarchies as the input information, the same output as that of a connected neuronal structure layer 1 made up of N hierarchies of neuron layers can be obtained even when the connected neuronal structure layer 1 is not actually formed of N hierarchies of neuron layers.

Next explained is a connected neuronal structure device according to the second embodiment of the invention.

The connected neuronal structure device according to the second embodiment is different from the first embodiment in method of controlling the growth of neurons by the neuron setting layer 3. That is, in the second embodiment, growth of neurons is controlled by photon delivery. An example is shown in Fig. 12. A two-dimensional optical waveguide array is formed on the neuron setting layer 3. More specifically, the two-dimensional optical waveguide array includes a plurality of parallel linear optical fibers 11 and a plurality of parallel linear control signal lines 12 crossing the optical fibers 11 at right angles. Intervals of the optical fibers 11 and those of the control signal lines 12 are determined in accordance with neurons to be grown.

A semiconductor laser 13 is provided at one end of each optical fiber 11 as a light source such that laser beams from the semiconductor laser 13 can be injected to the core from the end surface of each optical fiber 11. A semiconductor laser capable of emitting ultraviolet (UV), red (R), green (G), blue (B) or infrared ray (IR) light is used as the semiconductor laser 13. More specifically, for example, a GaN semiconductor laser may be used as the semiconductor laser 13 capable of emitting ultraviolet or blue light, an AlGaInP semiconductor laser may be used as the semiconductor laser 13 for red emission, a ZnSe semiconductor laser may be used as the semiconductor laser for green emission, and a GaAs semiconductor laser may be used as the semiconductor laser 13 for red emission.

The semiconductor lasers 13 at respective ends of the optical fibers 11 and the control signal lines 12 can be driven by a horizontal driving circuit and a vertical driving circuit, both not shown.

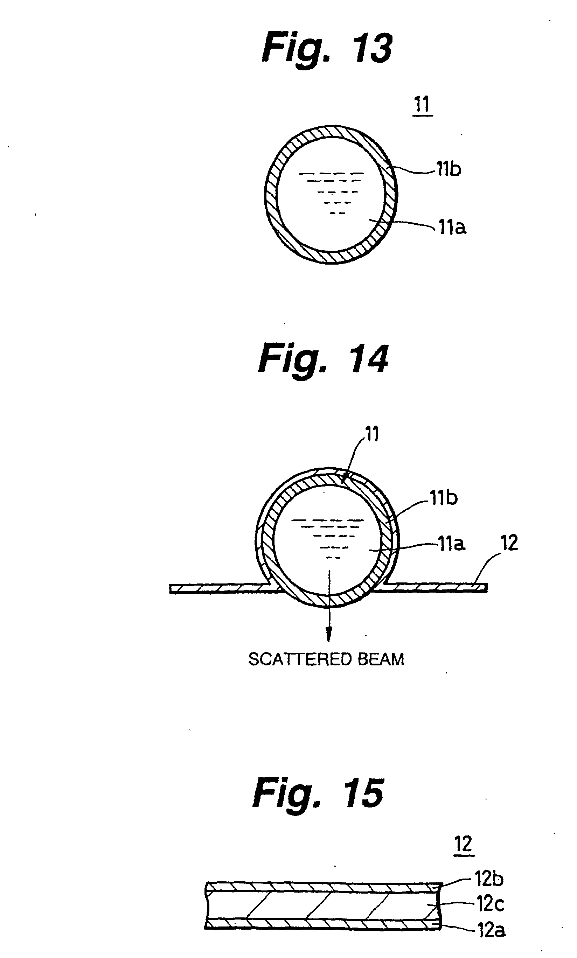

Fig. 13 shows a cross-sectional structure of the optical fiber 11. As shown in Fig. 13, the optical fiber 11 is made up of a liquid core 11a and a solid cladding 11b around it. The liquid used to form the core 11a is selected in accordance with the requirement. For example, water or ethyl alcohol containing hyperfine particles of an oxide dispersed therein is appropriate for that use. Material of the cladding 11b may be plastic or glass generally used as the material of optical fibers. The optical fiber 11 can be made by, for example, forming a thick plastic preform filled with a liquid in its center and thereafter extending it, or by filling the interior space of a hollow optical fiber with a liquid.

Fig. 14 is a cross-sectional view of an intersection of an optical fiber 11 and a control signal line 12. As shown in Fig. 14, the control signal line 12 defines a concave surface in contact with the outer circumferential surface of the optical fiber 11 excluding a part of the circumferential portion thereof along the display surface of the display. As shown in Fig. 15, the control signal line 12 has a piezoelectric element structure sandwiching a piezoelectric material 12c between a pair of metal electrodes 12a, 12b, and the lower metal electrode 12a is in contact with the outer circumferential surface of the optical fiber 11. In this case, since the surface of the piezoelectric element as the control signal line 12 in contact with the cladding 11b is a surface of the metal electrode 12a and has a high reflectance, the light scattering inside the core 11a is efficiently extracted externally from the potion not covered by the control line 12. For applying a voltage to the piezoelectric element, there is a method of grounding one of the metal electrodes 12a, 12b and applying a positive voltage to the other, for example. Usable as the piezoelectric material 12c of the piezoelectric element are, for example, polycrystalline or ceramic materials such as $PbTiO_3$, PZT, PLZT and ZnO, and polymeric materials such as polyvinylidene fluoride (PVDF). For making the piezoelectric element as the control signal line 12, if a polycrystalline or ceramic material is used as the piezoelectric material 11c, then the method of sequentially stacking a metal, piezoelectric material and metal by sputtering, vacuum evaporation, screen printing or the like, using an adequate mask under the condition with optical fibers 11 in parallel alignment, can be used. If PVDF is used as the piezoelectric material 12c, there can be used the method of preparing a laminated film by forming metal films on opposite surfaces of a PVDF film and bonding stripe cuts of the laminated film on the outer circumferential surface of the optical fiber 11.

Diameter of the optical fiber 11 is, for example, in the range of 200 to 300 μm, and width of the control signal line 12, i.e. width of the piezoelectric element (corresponding to the length of a pixel in the lengthwise direction of the optical fiber 11), is about 1 mm, for example. To ensure the light to effectively scatter in the lengthwise direction of the optical fiber 11, since a length around ~μm is sufficient as the length L of the bubble generating region inside the core 11a in the lengthwise direction of the optical fiber 11, the width of the piezoelectric element in the order of 1 mm is a sufficiently large value.

The second embodiment generates bubbles by generating ultrasonic waves, using as the vibrator the piezoelectric element forming the control signal line 12 in contact with the outer circumferential surface of the optical fiber 11, and by bringing about cavitation in the liquid core 11a by means of the ultrasonic waves. Exemplary procedures thereof are explained below.

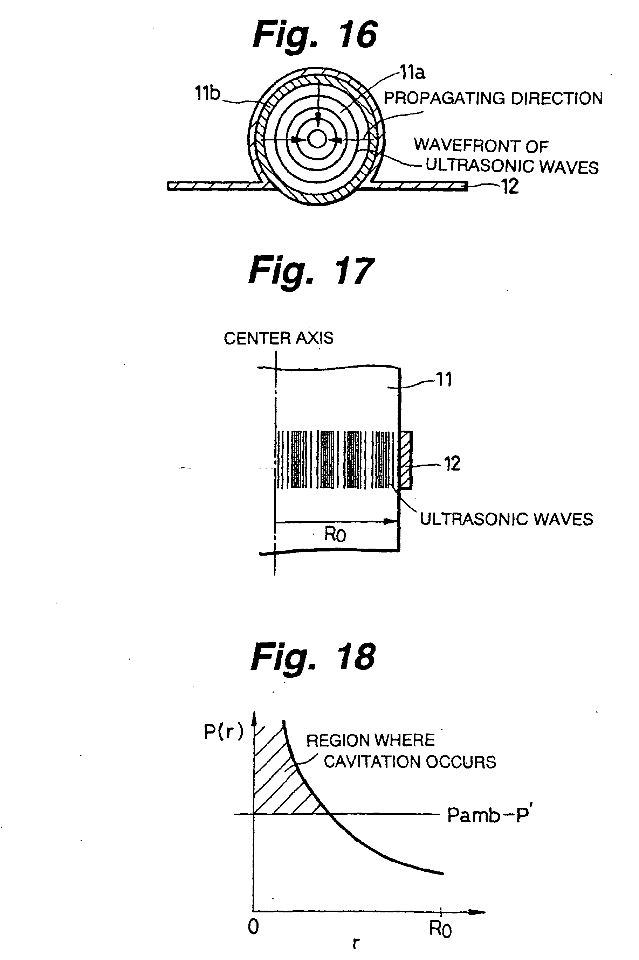

Fig. 16 shows an aspect of ultrasonic waves generated by using the control signal line 12 made of the piezoelectric element as the vibrator. As shown in Fig. 16, ultrasonic waves radiated by vibration of the piezoelectric element and propagating through the optical fiber 11 are gradually constringed toward the central axis of the optical fiber 11 because of the concave contact surface of the piezoelectric element with the optical fiber 11. In this case, when the sonic intensity at a distance r from the center axis of the optical fiber 11 is $I(r)[W/m^2]$, the following relation is established.

$$I(r) = I_{rim} \cdot 2\pi R_0 L / 2\pi rL = (R_0/r) I_{rim} \qquad (1)$$

where $I_{rim}$ is the sonic intensity $[W/m^2]$ on the outermost circumferential surface of the optical fiber 11, $R_0$ is the outer diameter of the optical fiber 11, L is the control signal line 12, i.e. the piezoelectric element, in the axial direction of the optical fiber 11.

Fig. 17 shows an aspect of propagation of ultrasonic waves in a cross-sectional view taken in the lengthwise direction of the optical fiber 11 (longitudinal cross-sectional view). Since sonic waves are longitudinal waves, compression waves in the direction perpendicular to the center axis of the optical fiber 11 are generated, and the sonic intensity $I[W/m^2]$ relative to the sound pressure $P[N/m^2]$ is given by

$$I = P^2 / \rho C_s \qquad (2)$$

where $\rho$ is the density of the liquid, and $C_s$ is the sonic velocity. If the intensity I of sonic waves generated by the piezoelectric element is an independent variable, then the sound pressure $P_{rim}$ on the outer circumferential surface of the optical fiber 11 is

$$P_{rim}=(I\rho C_s)^{1/2} \qquad (3)$$

Assuming that the optical fiber 11 is put under the ambient air pressure $P_{amb}$ (normally the atmospheric pressure), then the condition for bringing about cavitation is expressed by the following inequality.

$$(P_{amb}-P(r))-P'<0 \qquad (4)$$

The left side of Inequality (4) can be negative because, as shown in Fig. 18, P(r) exceeds $P_{amb}-P'$ when r is sufficiently small.

It is known from Inequality (4) that a liquid having a high saturation vapor pressure in the atmospheric pressure is preferably used to decrease the power of the ultrasonic waves to be generated by the piezoelectric element lower than Inequality (4).

Here is shown an example of the power of ultrasonic waves generated by the piezoelectric element forming the control signal line 12. Assuming the case where bubbles are generated due to cavitation at the position of r=10μm, in case of $R_0$=100μm, since cavitation takes place at, for example, I(r)=0.3W/cm$^2$, from Equation (1), it becomes $I_{rim}=(r/R_0)I=(10/100) \cdot 0.3=0.03$W/cm$^2$.

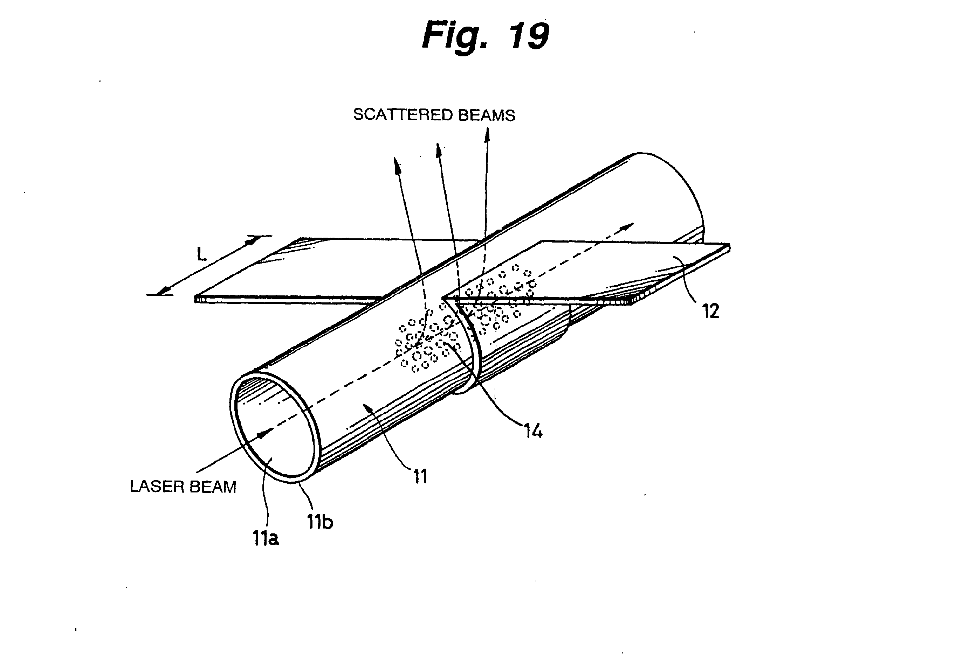

Fig. 19 shows how the incident light (laser beams) propagating through the optical fiber 11 is scattered by bubbles 14 generated in the core 11a of a section by cavitation and extracted externally of the display surface of the optical fiber 11. This corresponds to the lit status of the pixel.

When the power applied to the piezoelectric element is cut off, it becomes P(r)=0, then the inequality (4) establishes no longer, and the light is guided through the optical fiber 11 without being scattered. This corresponds to the status without emission of light.

Assuming that the diameter ($2R_0$) of the optical fiber 11 is 200 μm and taking $C_s\sim$1km/s, the time required for the switching of light is in the order of $R_0/C_s\sim$0.1μsec, and sufficiently short.

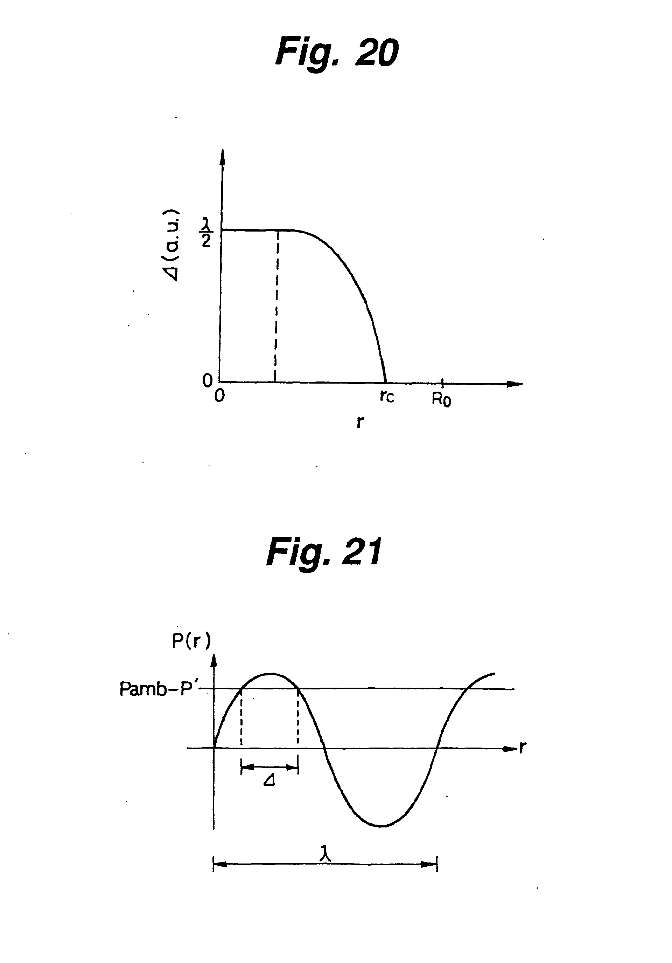

Fig. 20 shows a distribution of radial directions of the space length Δ satisfying the inequality (4). If the value of r is $r_c$ when both sides of the inequality (4) become equal, the following is established.

$$(P_{amb}-P(r_c))-P'=0 \qquad (5)$$

At $r_c$, infinitely small bubbles 14 begin to generate. In a central part of the optical fiber 11, namely, at r~0, Δ becomes one half the wavelength λ of the ultrasonic waves. The size of the bubbles (diameter) is proportional to Δ.

By appropriately designing the shape of the contact surface of the piezoelectric element as the control signal line 12 with the optical fiber 11, bubbles 14 can be controlled to have a distribution substantially symmetrical with respect to the center axis of the optical fiber 11, for example, as shown in Fig. 21, instead of a random distribution.

As understood from Equations (1) through (4), $r_c$ can be controlled by the sonic intensity I of ultrasonic waves generated by the piezoelectric element as the control signal line 12.

When L=1mm and $r_c$=100μm, the number of bubbles $N_c$ generated in each section by cavitation is as follows.

$$N_c\sim L\pi r_c^2/\lambda^3\sim 1mm\cdot\pi\cdot(100\mu m)^2/(20\mu m)^3$$

$$\sim 4\times10^3/\text{section}\cdot\text{column}$$

That is, about 4000 bubbles 14 are typically generated in each section. Note here that $\upsilon$ is the frequency of the ultrasonic waves, and $\lambda=C_s/\upsilon\sim$1km/s/50MHz$\sim10^3/5\times10^7=2\times10^{-5}$m=20μm.

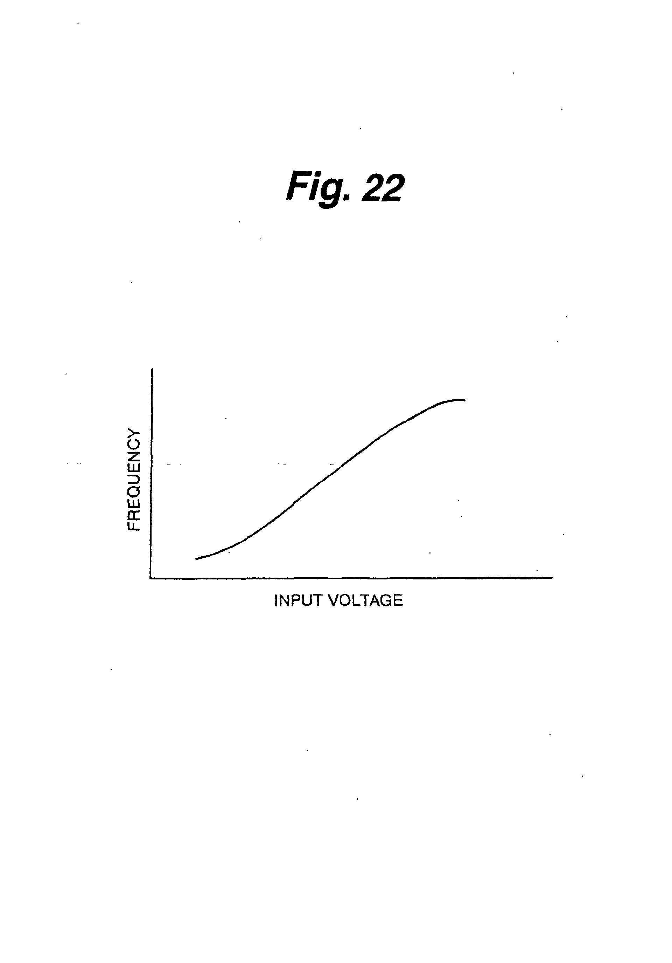

The frequency $\upsilon$ of the ultrasonic waves, i.e. the wavelength λ, can be controlled by the input voltage to the piezoelectric element. An example of dependency of the frequency of ultrasonic waves to the input voltage is shown in Fig. 22. More specifically, by using voltage controlled crystal oscillator VCXO, for example, as the piezoelectric element, the output frequency can be controlled by the input voltage. Therefore, the wavelength λ of ultrasonic waves generated by the piezoelectric element can be controlled.

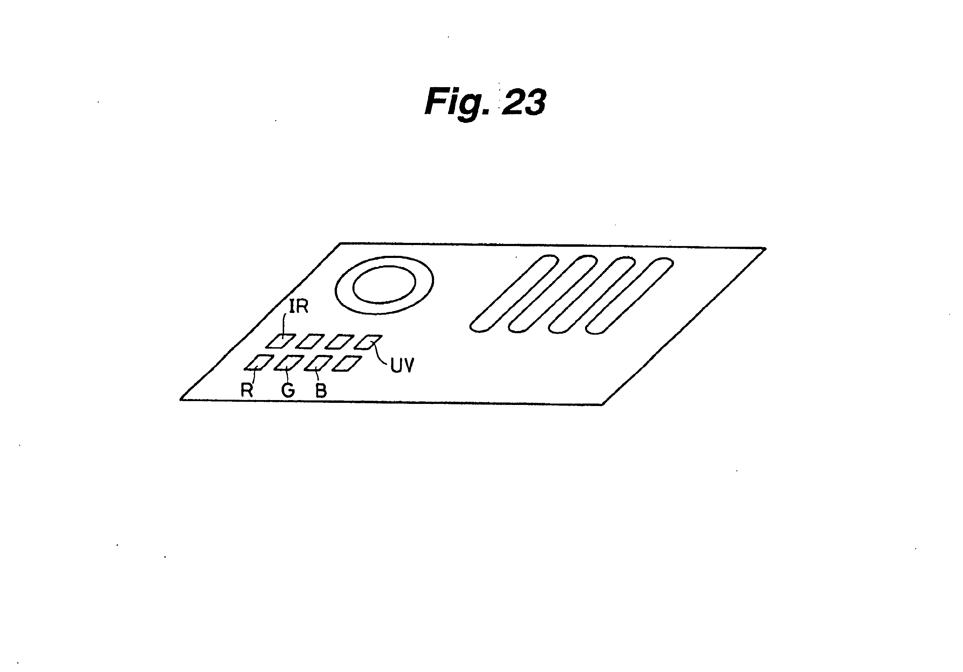

Taking the above explanation as the premises, a method of controlling the growth of neurons according to the second embodiment will be explained below. That is, in accordance with neurons to be grown, an optical fiber 11 and a control signal line 12 are selected. Then the semiconductor laser 13 provided at one end of the selected optical fiber 11 is driven to introduce a laser beam from the semiconductor laser 13 to the core 11a of the optical fiber 11. At the same time, a predetermined voltage is applied by means of the control signal line 12 between the pair of metal electrodes 12a, 12b of the control signal line 12 to drive the piezoelectric element, thereby bring about cavitation and generate bubbles 14. Thus the bubbles 14 scatter the ultraviolet, red, green, blue or infrared ray laser beam introduced into each optical fiber 11 such that the scattered light is extracted to the display surface. By controlling the intensity distribution, wavelength distribution and spatial distribution of this light, distribution of growth of neurons can be controlled. Fig. 23 shows a pattern of photo delivery in a two-dimensional plane. In this case, these beams of light can control the polarization field of the culture liquid in which neurons grow, or can directly act to neurons.

Next explained is a connected neuronal structure device according to the third embodiment of the invention.

The connected neuronal structure device according to the third embodiment is different from the first embodiment in the method of controlling the growth of neurons by the neuron setting layer 3. That is, in the third embodiment, growth of neurons is controlled by controlling the vibration field. An example thereof is shown in Fig. 24. As shown in Fig. 24, a piezoelectric material layer (not shown) is formed on the neuron setting layer 3, a pair of comb-shaped electrodes 21a, 21b adjusted in positions, size and other factors in accordance with neurons to be grown are formed thereon. By applying an adequate voltage to the comb-shaped electrodes 21a, 21b, surface acoustic waves (SAW) can be generated. Then by controlling the vibration field generated thereby to control behaviors of ions in the culture liquid for growing neurons in, for example, distribution of growth of neurons can be controlled via partial resonance of axial filaments of neurons. Alternatively, influences of the vibration field to growth of neurons can be controlled. Fig. 25 shows an exemplary distribution of the vibration field in the two-dimensional plane.

Next explained is a connected neuronal structure device according to the fourth embodiment of the invention.

The connected neuronal structure device according to the fourth embodiment is different from the first embodiment in the method of controlling the growth of neurons by the neuron setting layer 3. That is, in the fourth embodiment, growth of neurons is controlled by changing the volume or controlling the surface configuration. An example thereof is shown in Fig. 26. As shown in Fig. 26, an arrangement of four electrodes 32a, 32b, 32c, 32d around a fine volume-variable substance 31 such as gel on the neuron setting layer 3 is formed in a two-dimensional array of a layout, size, etc. in accordance with neurons to be grown. The volume-variable substance 31 can be directly acted upon to change the volume by applying appropriate voltages to these electrodes 32a, 32b, 32c, 32d. Alternatively, swelling of the volume-variable substance 31 is controlled by locally changing pH in the culture liquid by adjusting potentials of the electrodes 32a, 32b, 32c, 32d. Then, through changes of the surface configuration caused by the volume changes of the volume-variable substance 31, growth distribution of neurons can be controlled, or changes of the efficiency of teacher signals can be measured. Fig. 27 shows an exemplary surface configuration in the two-dimensional plane by the two-dimensional array of the volume-variable substance 31. In Fig. 27, reference numeral 32 denotes a straight V groove, 33 denotes a straight V groove having lateral grooves, 33 denotes a square V groove, and 35 denotes high-order structure of a group of grooves.

Next explained is a connected neuronal structure device according to the fifth embodiment of the invention.

Fig. 28 shows the connected neuronal structure device according to the fifth embodiment of the invention. As shown in Fig. 28, in this connected neuronal structure device, the bus line 4 connected to the output terminal of the neuron observation layer 2 includes an electrical bus line portion 4a and an optical bus line portion 4b, and the bus line 5 connected to the output terminal of the neuron setting layer 3 includes an electrical bus line portion 5a and an optical bus line portion 5b. In the other respects, the fifth embodiment is the same as the first embodiment, so its explanation is omitted.

The fifth embodiment can use both electric signals and optical signals as signals to be applied to or to be extracted from the connected neuronal structure layer, and is therefore available for more diverse control of growth and development.

Next explained is a connected neuronal structure device according to the sixth embodiment of the invention.

Fig. 29 shows the connected neuronal structure device according to the sixth embodiment. The connected neuronal shown here has a tandem structure stacking a plurality of connected neuronal structure devices of the fifth embodiment in multiple stages.

The connected neuronal structure device having the tandem structure can carry out characteristic analysis of neuronal systems in more diverse fashions, and simultaneously, it can perform more various kinds of information processing through information processing by each of multiple stages of connected neuronal structure layers 1.

Next explained is a connected neuronal structure device according to the seventh embodiment of the invention.

The connected neuronal structure device according to the seventh embodiment provides a kind of phase shift at the connection interface between the connected neuronal structure layer 1 and the neuron setting layer 3, and/or between the connected neuronal structure layer 1 and the neuron observation layer 2. For example, by arranging the pad electrodes Q in the neuron setting layer 3 as shown in Fig. 30, a phase shift is provided.

Such a phase shift increases the freedom in connection between the connected neuronal structure layer 1, and the neuron setting layer 3 and/or the neuron observation layer 2, and therefore contributes to realization of a connected neuronal structure device having a higher function.

Next explained is a connected neuronal structure device according to the eighth embodiment of the invention.

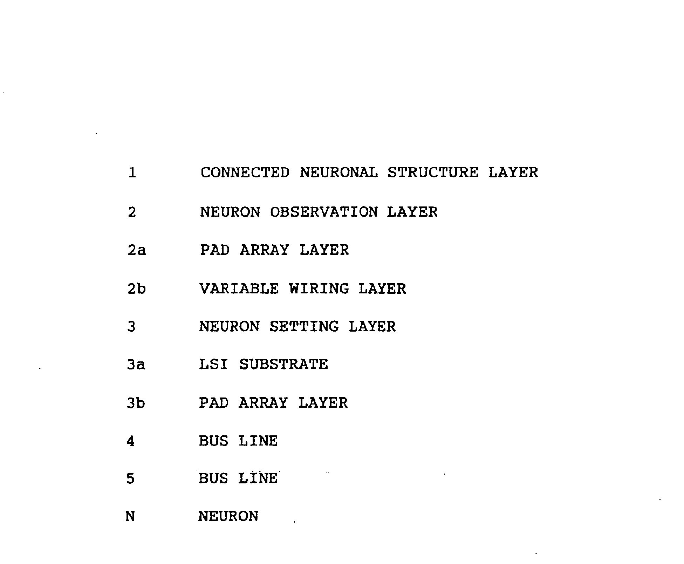

The connected neuronal structure device according to the eighth embodiment provides a phase shift at the connection interface between the connected neuronal structure layer 1 and the neuron setting layer 3, and/or between the connected neuronal structure layer 1 and the neuron observation layer 2 by a method different from that of the seventh embodiment. For example, by arranging the pad electrodes Q in the neuron setting layer 3 in two stages as shown in Fig. 32, the phase shift is provided. In this case, the input to neurons N in the second layer, for example, can be controlled by neurons N in the first layer and the pad electrodes Q in the second stage.

The eighth embodiment ensures more freedom in connection of the connected neuronal structure layer 1 with the neuron setting layer 3 and/or the neuron observation layer 2, and therefore contributes to realization of a connected neuronal structure device with a remarkably high function.

Some specific embodiments of the invention have been described heretofore; however, the invention is not limited to those embodiments, but rather involves various changes and modifications within the technical concept of the present invention.

For example, although the first embodiment uses a liquid crystal layer LC made of a polymeric side chain liquid crystal, in addition to that, polyvinyl cinnamate and polyimide, for example, are especially recommendable as materials capable of controlling the growth of neurons, in particular, in terms of growth direction. If polypeptide is used as the polymer, it does not always have a liquid crystal phase. However, it includes molecules capable of optically orienting polymers such as azobenzene in its side chains, and can control orientation of polymers with polarized light. Polyimide is the most popular polymer for rubbing orientation of liquid crystal molecules in liquid crystal displays. Orientation direction by polyimide can be also changed by rubbing the polyimide film beforehand to regulate the growth in a particular direction, and thereafter irradiating polarized light whenever necessary.

Basically, controlling the growth direction of neurons in accordance with orientation of liquid crystal molecules is just the role of polymeric liquid crystals. Therefore, by using an optically diversifying compound with a low molecular weight, such as molecules having azo radicals (for example, brilliant yellow and metylred), a liquid crystal layer in contact therewith can be oriented, and the scheme of growth control of neurons can be also selected. In this case, vapor deposition, spin coating, or other method typically used for thin films can be used to obtain the optically diversifying compound, and so is it to obtain the liquid crystal layer.

Recently reported is realization of optical orientation by a polymer having cumarin. Polymers of this system are also effective for this purpose (18th International LC Committee 27B-6-0).

As described above, the invention can realize connected neuronal structure devices hopeful for wide applications, by breaking the limit of conventional neuronal systems to enable detection of signals from individual neurons for more detailed characteristic analyses.

## Claims

1. A connected neuronal structure system comprising:

   a connected neuronal structure; and
   a plurality of element layers connected to said connected neuronal structure in different sites.

2. A connected neuronal structure device **characterized in** having a connected neuronal structure layer interposed between a pair of element layers.

3. The connected neuronal structure device according to claim 2 wherein said element layers include a plurality of electronic elements.

4. The connected neuronal structure device according to claim 2 wherein said element layers include a plurality of optical elements and a plurality of electronic elements.

5. The connected neuronal structure device according to claim 2 wherein one of said pair of element layers forms a setting system of said connected neuronal structure layer, and the other element layer forms an observation system of said connected neuronal structure layer.

6. The connected neuronal structure device according to claim 5 wherein said element layer forming the observation system of said connected neuronal structure layer includes a two-dimensional array of pads or gates.

7. The connected neuronal structure device according to claim 5 wherein said element layer forming the observation system of said connected neuronal structure layer includes a two-dimensional array of pads or gates, and a variable wiring layer.

8. The connected neuronal structure device according to claim 5 wherein said element layer forming the setting system of said connected neuronal structure layer is configured to generate a two-dimensional electric field.

9. The connected neuronal structure device according to claim 5 wherein said element layer forming the setting system of said connected neuronal structure layer is configured to carry out two-dimensional delivery of light.

10. The connected neuronal structure device according to claim 5 wherein said element layer forming the setting system of said connected neuronal structure layer is configured to generate a two-dimensional vibration field.

11. The connected neuronal structure device according to claim 5 wherein said element forming the setting system of said connected neuronal structure layer contains a substance variable in volume, which is arranged in a two-dimensional array.

12. The connected neuronal structure device according to claim 5 wherein said element layer forming the setting system of said connected neuronal structure layer performs at least the function of controlling the growth of neurons and the function of educating said connected neuronal structure layer.

13. The connected neuronal structure device according to claim 2 wherein said connected neuronal structure layer is a two-dimensional neuronal system.

14. The connected neuronal structure device according to claim 2 wherein said connected neuronal structure layer is a three-dimensional neuronal system.

15. The connected neuronal structure device according to claim 2 wherein said connected neuronal structure device has a structure stacking multiple stages of said connected neuronal structure layers.

# Fig. 1

# Fig. 2

PROBES

CULTURED
NEURONAL SYSTEM

PROBES

# Fig. 3

# Fig. 4

# Fig. 5

<u>2</u>

2b

2a

Fig. 6

# *Fig.* 7

Fig. 8

# Fig. 9

LC      LC

Q                    Q

3a

Fig. 10

2a

ELECTRIC FIELD

Fig. 11

# Fig. 12

EMITTING

13

12

11

3

EP 1 329 965 A1

# *Fig. 13*

11

11b

11a

# *Fig. 14*

11

11b

11a

12

SCATTERED BEAM

# *Fig. 15*

12

12b

12c

12a

## *Fig. 16*

11b — 11a
PROPAGATING DIRECTION

WAVEFRONT OF
ULTRASONIC WAVES

— 12

## *Fig. 17*

CENTER AXIS

— 11

— 12

ULTRASONIC WAVES

$R_0$

## *Fig. 18*

$P(r)$

REGION WHERE
CAVITATION OCCURS

$P_{amb} - P'$

0            $R_0$

r

# Fig. 19

SCATTERED BEAMS

L

12

14

11

LASER BEAM

11b

11a

EP 1 329 965 A1

# Fig. 20

# Fig. 21

# *Fig. 22*

Fig. 23

# Fig. 24

EP 1 329 965 A1

Fig. 25

Fig. 26

EP 1 329 965 A1

## Fig. 27

EP 1 329 965 A1

# Fig. 28

# Fig. 29

# Fig. 30

N

2

Q
Q
3

# Fig. 31

3RD LAYER
2ND LAYER
1ST LAYER

N

2

Q
Q
3

Q
Q

1        CONNECTED NEURONAL STRUCTURE LAYER

2        NEURON OBSERVATION LAYER

2a       PAD ARRAY LAYER

2b       VARIABLE WIRING LAYER

3        NEURON SETTING LAYER

3a       LSI SUBSTRATE

3b       PAD ARRAY LAYER

4        BUS LINE

5        BUS LINE

N        NEURON

# INTERNATIONAL SEARCH REPORT

| International application No. |
|---|
| PCT/JP00/07376 |

| A. CLASSIFICATION OF SUBJECT MATTER |
|---|
| Int.Cl$^7$   H01L51/10, 27/04 |
| According to International Patent Classification (IPC) or to both national classification and IPC |

| B. FIELDS SEARCHED |
|---|
| Minimum documentation searched (classification system followed by classification symbols) |
| Int.Cl$^7$   H01L51/00-51/40, 27/00, 27/04, 41/08, G02B6/20 |

Documentation searched other than minimum documentation to the extent that such documents are included in the fields searched
| Jitsuyo Shinan Koho | 1922-1996 | Toroku Jitsuyo Shinan Koho | 1994-2001 |
|---|---|---|---|
| Kokai Jitsuyo Shinan Koho | 1971-2001 | Jitsuyo Shinan Toroku Koho | 1996-2001 |

Electronic data base consulted during the international search (name of data base and, where practicable, search terms used)

## C. DOCUMENTS CONSIDERED TO BE RELEVANT

| Category* | Citation of document, with indication, where appropriate, of the relevant passages | Relevant to claim No. |
|---|---|---|
| A | US 5388169 A (Tokyo University of Agriculture and Technology), 07 February, 1995, Full text & JP 06-308452 A | 1-19 |
| A | JP 02-174153 A (Toshiba Corporation), 05 July, 1990 (05.07.90), Full text   (Family: none) | 1-19 |

☐ Further documents are listed in the continuation of Box C.  ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 15 January, 2001 (15.01.01) | 06 February, 2001 (06.02.01) |

| Name and mailing address of the ISA/ | Authorized officer |
|---|---|
| Japanese Patent Office | |
| Facsimile No. | Telephone No. |

Form PCT/ISA/210 (second sheet) (July 1992)